(19) Europäisches Patentamt / European Patent Office / Office européen des brevets

(11) **EP 1 897 215 B1**

(12) **EUROPEAN PATENT SPECIFICATION**

(45) Date of publication and mention
of the grant of the patent:
**30.12.2009 Bulletin 2009/53**

(51) Int Cl.:
***H03B 28/00*** (2006.01)     ***H03K 4/06*** (2006.01)

(21) Application number: **06765825.2**

(22) Date of filing: **22.06.2006**

(86) International application number:
**PCT/IB2006/052029**

(87) International publication number:
**WO 2006/137034 (28.12.2006 Gazette 2006/52)**

(54) **WIDEBAND RF PSEUDO-SINE SIGNAL GENERATOR**

BREITBAND-RF-PSEUDO-SINUSSIGNALGENERATOR

GENERATEUR DE SIGNAUX PSEUDO-SINUSOIDAUX RF LARGE BANDE

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **24.06.2005 EP 05300508**

(43) Date of publication of application:
**12.03.2008 Bulletin 2008/11**

(73) Proprietor: **NXP B.V.
5656 AG Eindhoven (NL)**

(72) Inventor: **TOURRET, Jean-Robert
F-75008 Paris (FR)**

(74) Representative: **Schouten, Marcus Maria et al
NXP B.V.
IP & L Department
High Tech Campus 32
5656 AE Eindhoven (NL)**

(56) References cited:
**GB-A- 1 390 510        US-A- 3 961 206
US-A1- 2004 085 102**

**Description**

Field of the invention

The present invention relates to the domain of signal generation devices, and more precisely to those adapted to output pseudo-sine signals.

By "pseudo-sine signals" are meant here signals that have a sine or quasi-sine shape.

Background of the invention

As is known by one skilled in the art, there is an increasing demand of "as pure as possible" sine waves or signals (which are continuous), especially in the domain of integrated circuits. For instance, sine signals are used to calibrate the central frequency of a radio frequency (RF) filter, a full-complex mixer used for image rejection, or an amplifier gain, or to perform test(s) such as Built-In Self Test (BIST). More generally, each time the transfer function of a device or circuit needs testing, or a functionality must be checked or tested, a pseudo-sine signal generator can be used.

Most of the generators use input square signals to generate pseudo-sine signals. When the pseudo-sine signals (or waves) need to be generated within a large frequency range (typically from a few MHz to a few GHz) the input square signals are generally generated in two steps : a frequency synthesizer with on-chip Voltage Controlled Oscillators (VCO) generates signals at higher frequencies (few GHz), and these signals are divided within a feedback loop of a PLL by high frequency dividers. The generated square signals generally have a duty cycle of 0.5, and their harmonic content is rich. So it is necessary to filter out their harmonics.

For harmonic filtering, it is possible to use high order filters comprising OTA (Operational Transconductance Amplifiers) combined to realize structures of the Butterworth or Chebychev type. These filters having a fixed cut-off frequency, they must be combined with passive components in order to be switched. Therefore they are not adapted to high frequencies.

It is also possible to use high order filters with transconductors tuned by a variable current (gm/C) and combined to realize structures of the Butterworth or Chebychev type. These filters can be used into generators having a linearly variable input frequency, but they are limited to a few hundred of MHz.

It is also possible to use LC filters tuned with varactors or switched capacitors. But the width of the working frequency range depends on the number of external components (varactors or switched capacitors) that are used. Therefore the generators in which these filters are used may be bulky and complex.

It is also possible to use simple RC 1$^{st}$ order filters with many switches coupled to their resistors and/or capacitors. But these filters exhibit poor filtering, are bulky (because of the number of switches that are required), and require an amplitude regulation at the output.

It is also possible to lock a PLL (Phase Locked Loop) on a RC wideband oscillator, and to regulate the amplitude of the oscillator in order its output be a quasi-sine wave (or signal). But, when the working frequency range needs to be tunable it is necessary to use an additional PLL and several RC oscillators, which renders the generator bulky and complex.

Examples of pseudo-sine signal generators with third harmonic rejection are disclosed in GB 1390510 and US 3,961,206.

Summary of the invention

The object of the present invention is to improve the situation and more precisely to offer a wideband RF pseudo-sine signal generator, i.e. a pseudo-sine signal generator intended for delivering RF pseudo-sine signals within a large frequency range (typically from a few MHz to a few GHz).

For this purpose, it provides a pseudo-sine signal generation device comprising at least:

- a differential tunable integration means arranged to generate differential triangular signals with a chosen constant output amplitude from input differential square signals, and
- a differential processing means arranged to apply a chosen transfer function to the differential triangular signals in order to reject at least a third harmonic thereof when the amplitude of the differential triangular signals is equal to the chosen constant output amplitude, and then to output pseudo-sine signals with a quasi-constant amplitude, and
- an additional harmonic rejection means coupled to said differential tunable integration means and arranged to reject the second harmonic of the differential triangular signals outputted by the differential tunable integration means before they feed the differential processing means;

The device according to the invention may include additional characteristics considered separately or combined, and notably:

- it may further comprise an amplitude detection means arranged to compare the output amplitude of the differential triangular signals with the chosen constant output amplitude in order to deliver a control signal representative of a difference between these amplitudes, and its tunable differential integration means may be arranged to adjust the output amplitude of the differential triangular signals it outputs depending on the control signal in order this output amplitude be equal to the chosen constant output amplitude;
- its additional harmonic rejection means may comprise a regulation loop for regulating the common mode of the differential triangular signals and a cancellation loop for cancelling a possible offset of the differential triangular signals;
- its differential processing means may be a bipolar differential amplifier having a transfer function $V_{out}$ proportional to $\tanh(V_{in}/2V_t)$ where $V_t = kT/q$, k being the Boltzmann constant, T being the absolute temperature in Kelvin and q being the electron charge. In this case the chosen constant output amplitude is equal to $\alpha*V_t$, where $\alpha$ is a constant, for instance included between 3 and 4, and preferably equal to 3.3;
- in a variant its differential processing means may be a MOS differential amplifier having a transfer function $V_{out}$ depending on its polarization current and geometry. In this case the chosen constant output amplitude is equal to a value depending on the polarization current and geometry of the MOS differential amplifier;
- its differential tunable integration means may comprise a capacitor means and a tunable transconductor feeding the capacitor means and tunable by means of a control current In this case the amplitude detection means is arranged to deliver a control signal which defines the control current;
- in a variant its differential tunable integration means may comprise a transconductor and a tunable capacitor means fed by the transconductor and tunable by means of a control voltage. In this case the amplitude detection means is arranged to deliver a control signal which defines the control voltage;
- in another variant its differential tunable integration means may comprise a current amplifier and a tunable capacitor means fed by the current amplifier and tunable by means of a control voltage. In this case the amplitude detection means is arranged to deliver a control signal which defines the control voltage;
- in another variant its differential tunable integration means may comprise a capacitor means and a tunable current amplifier feeding the capacitor means and having a gain tunable by means of a control current or voltage. In this case the amplitude detection means is arranged to deliver a control signal which defines the control current or voltage;
- it may further comprise a generator means arranged to generate the input differential square signals;
- it may constitute at least a part of an integrated circuit (IC).

Brief description of the drawings

Other features and advantages of the invention will become apparent on examining the detailed specifications hereafter and the appended drawings, wherein:

- Fig. 1 schematically illustrates an example of embodiment of a pseudo-sine signal generation device according to the invention,
- Fig.2 schematically illustrates a diagram of the rejection by a bipolar differential amplifier of the differential triangular signal odd harmonics as a function of the differential triangular signal amplitude, and
- Fig.3 schematically illustrates a diagram of the time variations of the differential triangular signals ($V_{in}(t)$) and pseudo-sine signals ($V_{out}(t)$).

The appended drawings may not only serve to complete the invention, but also to contribute to its definition, if need be.

Description of the preferred embodiment

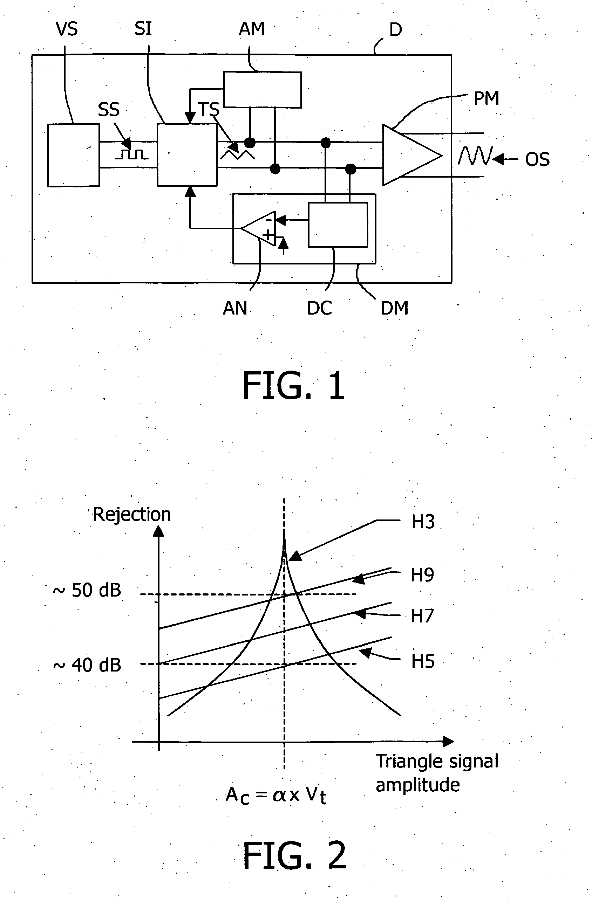

Reference is initially made to Fig. 1 to describe an example of embodiment of a pseudo-sine signal generation device (hereafter "generator") D according to the invention.

In the following description it will be considered that the generator D is intended for generating a pseudo-sine test signal for calibrating a filter. But it is important to notice that the invention is not limited to this type of application.

Indeed the invention may apply wherever pseudo-sine signals (or waves) are needed, and notably in any integrated circuit having a frequency synthesizer generating square signals (or waves), or in any test such as Built In Self Test (BIST), test signal injection at the input of an amplification chain (for test or automatic gain setting), or test signal injection at the input of any device to determine its transfer curve.

As illustrated in Fig. 1, a generator D according to the invention comprises at least a tunable differential signal integrator SI combined with a differential signal processing module PM.

The tunable differential signal integrator (hereafter "integrator") SI is arranged to generate differential triangular signals TS with a chosen constant output amplitude from differential square signals SS it receives on its differential inputs.

In the following description it will be considered that the differential square signals SS are voltages generated by a voltage source VS. But the differential square signals SS could be currents generated by a current source.

As it is illustrated in Fig.1, the source VS, which delivers the differential square signals SS, may be part of the generator D. But this source may be also external to the generator D. For instance it may be a frequency synthesizer with on-chip Voltage Controlled Oscillators (VCO), such as the one used in a transceiver of a mobile phone.

The integrator SI may comprise a constant transconductor (I = gm * Vin, where Vin represents the square signals SS outputted by the differential voltage source VS) and a tunable or variable capacitor (or varicap) connected to the output of the transconductor and arranged to perform a time integration onto the square signals SS to generate triangular signals TS. In this case the capacitor's value is tuned by a control voltage.

In a variant the integrator SI may comprise a constant capacitor, arranged to perform a time integration onto the square signals SS to generate triangular signals TS, and a tunable transconductor feeding the constant capacitor and tunable by means of a control current.

In the case of differential currents SS (outputted by a differential current source), the integrator SI may comprise a current amplifier (I = G * Iin, where Iin represents the square signals SS), with a fixed gain, and a variable or tunable capacitor (or varicap) connected to the output of the current amplifier and arranged to perform a time integration onto the square signals SS to generate triangular signals TS. In this case the capacitor's value is tuned by a control voltage.

In a variant the integrator SI may comprise a constant capacitor, arranged to perform a time integration onto the square signals SS to generate triangular signals TS, and a tunable or variable current amplifier feeding the constant capacitor and having a gain tunable by means of a control current or voltage (depending on the internal structure of the integrator SI).

The amplitude of the outputted triangular signals TS must remain equal or quasi-equal to a chosen constant amplitude $A_C$ which depends on the type of the differential signal processing module (hereafter "processing module") PM, as explained below.

For this purpose, the generator D preferably (and as illustrated) comprises an amplitude detection module DM arranged to compare the differential triangular signals TS outputted by the integrator SI with the chosen constant amplitude $A_C$ and to deliver a signal representative of the difference therebetween. For instance, the amplitude detection module DM comprises i) a differential amplitude comparator DC fed with the differential triangular signals TS outputted by the integrator SI and intended for comparing them with the chosen constant amplitude $A_C$ and to deliver a signal representative of the amplitude difference therebetween, and ii) a voltage controlled current or voltage source AN defining an error (or control) signal from the signal delivered by the differential amplitude comparator DC.

More precisely, when the integrator SI comprises a constant capacitor and a tunable transconductor, the amplitude detection module DM comprises a voltage controlled current source (VCCS) AN, which outputs an error current defining a control current for tuning the transconductor. When the integrator SI comprises a varicap and a constant transconductor, the amplitude detection module DM comprises a voltage controlled voltage source (VCVS) AN, which outputs an error voltage defining a control voltage for tuning the varicap.

When the integrator SI comprises a constant capacitor and a tunable current amplifier, the amplitude detection module DM comprises a VCCS or VCVS (AN), which outputs an error current or voltage defining a control current or voltage for tuning the current amplifier. When the integrator SI comprises a varicap and a current amplifier with a fixed gain, the amplitude detection module DM comprises a voltage controlled voltage source (VCVS) AN, which outputs an error voltage defining a control voltage for tuning the varicap.

In both cases the error signal (current or voltage) is representative of the gap of the current triangular signal amplitude with respect to the chosen constant amplitude $A_C$. So, when the triangular signal amplitude differs from the chosen constant amplitude $A_C$ by a value represented by the error (or control) signal it has received from the amplitude detection module DM, the integrator SI modifies its time constant as a function of said error signal, in order the triangular signal amplitude be again equal to the chosen constant amplitude $A_C$.

The processing module PM is arranged to apply a chosen transfer function to the differential triangular signals TS outputted by the integrator SI in order to reject at least the third harmonic H3 they contain and then to output pseudo-sine signals with a quasi-constant amplitude.

It is recall that the differential triangular signals TS comprise odd and even harmonics (and notably a second one H2, a third one H3, a fifth one H5, a seventh one H7, and a ninth one H9). As it is known by the man skilled in the art, when one rejects from a triangular signal its third harmonic H3 (and also when its fifth harmonic H5 is sufficiently lowered), the resulting signal looks like a sine signal or a tanh (hyperbolic tangent) signal (which is quite similar to a sine signal in a Taylor's development). So without the third harmonic H3 (and preferably with a low fifth harmonic H5), a triangular signal looks like a pseudo-sine signal.

As it is illustrated in Fig.2, the rejection of the differential triangular signal third harmonic by a bipolar differential amplifier strongly varies with the amplitude of the differential triangular signals TS. More precisely this rejection appears to be fully effective when the amplitude of the differential triangular signal is (quasi-) equal to the chosen constant amplitude $A_C$. An equivalent rejection also appears into MOS (Metal Oxyde Semiconductor) differential amplifier.

This is the reason why it is of great importance that the amplitude of the triangular signals TS outputted by the integrator SI be as far as possible equal to the chosen constant amplitude $A_C$.

The chosen constant amplitude $A_C$ for which the rejection is optimal depends on the type of the processing module PM.

For instance, when the processing module PM is a bipolar differential amplifier the chosen constant amplitude $A_C$ must be equal to $\alpha * V_t$, where $\alpha$ is a constant and $V_t$ a parameter depending on the absolute temperature.

More precisely, $\alpha$ is a constant included between 3 and 4 and preferably, equal to 3.3.

$V_t$ is a parameter which appears in the transfer function $V_{out}(t)$ of the bipolar differential amplifier which is defined hereafter and represents the pseudo-sine signals OS outputted by the processing module PM:

$$V_{out}(t) \text{ oc } \tanh\left(\frac{V_{in}(t)}{2V_t}\right)$$

where tanh is the hyperbolic tangent, $V_{in}(t)$ represents the differential triangular signals TS to process (third harmonic rejection), and $V_t = kT/q$, k being the Boltzmann constant (k = 1.38 10$^{-23}$), T being the absolute temperature in Kelvin and q being the electron charge (1.6 10$^{-19}$).

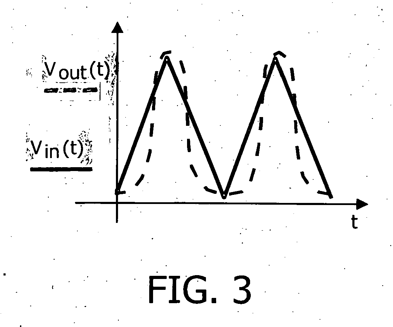

The time variations of the differential triangular signals $V_{in}(t)$ (TS) and pseudo-sine signals $V_{out}(t)$ (OS) are sketched in the diagram of Fig.3.

As it is illustrated in Fig.2, the transfer function of the bipolar differential amplifier PM also allows a good rejection of the fifth H5, seventh H7 and ninth H9 harmonics comprised into the differential triangular signals TS. Indeed, when the differential triangular signal amplitude is (quasi-) equal to $\alpha * V_t(A_C)$, the rejection of the fifth H5, seventh H7 and ninth H9 harmonics is confined within approximately 40 to 50 dB.

Of course, when the processing means PM is a MOS differential amplifier instead of a bipolar differential amplifier, the value of the chosen constant amplitude $A_C$ (for which the third harmonic rejection is optimal) will not be equal to $\alpha * V_t$. In this case, the chosen constant amplitude $A_C$ depends effectively on the polarization current and geometry (parameters w (gate width) and L (gate length)) of the MOS differential amplifier.

In order to improve the harmonic rejection and therefore the pseudo-sine shape of the signals OS outputted by the processing means PM, the generator D comprises, as illustrated in Fig. 1, an additional harmonic rejection module AM connected to the signal paths (or inserted) between the integrator SI and the processing module PM.

This additional harmonic rejection module AM is arranged to reject the second harmonic H2, which is comprised into the differential triangular signals TS outputted by the integrator SI.

The type of this additional harmonic rejection module AM depends on the signal type. For instance, when the differential triangular signal TS is a voltage, the additional harmonic rejection module AM comprises preferably two processing loops coupled to the integrator SI.

The first processing loop is a regulation loop, which is used for common mode regulation of the differential triangular signals TS. Let us assume that the differential triangular signal TS is equal to a voltage difference V2 - V1 (TS = V2 - V1). The average voltage (V2 + V1)/2 = $V_{aver}$ can be sensed with a resistive bridge of the regulation loop, connected between V2 and V1 (i.e. between the differential signal paths). If it is now assumed that the wanted common mode voltage is $V_{cm}$, then $V_{cm}$ and $V_{aver}$ can be the inputs of a feedback amplifier of the regulation loop which generates an error signal proportional to $V_{aver}$ - $V_{cm}$. So, the internal biasings in the integrator SI can be tuned with ($V_{aver}$ - $V_{cm}$), in order to get to a steady point defined by $V_{aver}$ = $V_{cm}$.

The second processing loop is a cancellation loop, which is used for offset cancellation of the differential triangular signals TS.

If one still[0] assumes that TS = V2 - V1, TS is derived from the signal paths to the inputs of a differential amplifier of the cancellation loop, which generates an error signal proportional to V2 - V1. This error signal is strongly low pass filtered into the cancellation loop so that the bandwidth of the cancellation loop is quite smaller than the minimum frequency of interest for TS. Then the differential internal biasings of the integrator SI are tuned with this error signal, in order to get to a steady point defined by (V2 - V1)$_{low\ pass\ out}$ =0.

Now, if the differential triangular signal TS is a current the additional harmonic rejection module AM above described may be fed by resistors mounted in parallel between the differential signal paths. These resistors allow to build a voltage from the differential current. This voltage is then re-used by the additional harmonic rejection module AM. The common mode voltage for the resistors can be VCC, or any suitable voltage source.

It is important to notice that the load of the processing module PM may be a constant resistor. In this case, the generator D does not need the additional harmonic rejection module AM. In fact, as the generator D is differential, there are a first output resistor connected between the first output signal path and VCC (or any other suitable voltage source) as a common mode voltage source, and a second output resistor connected between the second output signal path and VCC (or any other suitable voltage source).

It is also possible to further filter out higher order harmonics. For this purpose the generator D may comprise first and second output capacitors mounted in parallel respectively with the first and second output resistors above mentioned. Tunable versions of these first and second output capacitors (switch capacitors or varicaps) can be used in order to improve the efficiency of the filtering as a function of the signal's frequency.

Preferably, the pseudo-sine signal generation device (or generator) D, according to the invention, constitutes at least a part of an integrated circuit (IC), which may be realized in any technology used in chip factory, such as the MOS technology, the BiCMOS technology or the bipolar technology, for instance.

The generator according to the invention offers several important advantages:

- it allows to re-use the LO (local oscillator) signal generated by numerous frequency synthesizers;
- the output amplitude of the pseudo-sine signals is quite constant (quasi- constant), because the differential processing module (for instance a bipolar differential amplifier) is nearly completely switched (about 80 mV). Indeed, when the amplitude is equal to the chosen constant amplitude $A_C$, the differential amplifier of the processing module has used approximately 90 % of its current source, therefore if the amplitude of the triangular signals slightly varies the amplitude of the outputted pseudo-sine signals remains quasi-constant;
- it does not need any switch because the integrator linearly updates its integration constant as a function of frequency when it is coupled to the amplitude detection loop. Indeed, let us assume that the input frequency is Fin, and its associated period Tin = 1/Fin. The feedback loop of the amplitude detection means intends to get the triangular signals TS to the chosen constant amplitude $A_C$: only one integration time constant enables to linearly, increase the voltage from 0 to $A_C$, in a given time Tin/4. This integration time constant is given by $4*A_C/Tin$. From the generic equation $C * V = I * Tin$, one can see that V/Tin = I/C. So, if Tin changes, I, C or V must be tuned. As $V = 4*A_C =$ constant, only I and C can be changed, leading to two approaches: either one tunes I (in case where the integrator comprises a capacitor and the amplitude detection means comprises a VCCS) or one tunes C (in case where the integrator comprises a varicap and the amplitude detection means comprises a VCVS);
- it offers a constant rejection of H3, H5, H7 and H9 as a function of frequency, better than approximately 40 dB for each;
- it can be a low noise generator on account of the low number of integrators (around -130 dBc/Hz typically from a few Hz to hundreds of MHz, respectively to the carrier; output noise floor (or noise density ($V_{noise\ density}$) at the output) can be as low as $2\ nV/\sqrt{(Hz)}$ -it is recall that the noise voltage $V_n$ can be expressed as a function of the bandwidth of interest: $V_n\ [dB\mu V] = V_{noise\ density}\ [dB\mu V] + 10*log\ (bandwidth)).$

The invention is not limited to the embodiments of pseudo-sine signal generation device described above, only as examples, but it encompasses all alternative embodiments which may be considered by one skilled in the art within the scope of the claims hereafter.

**Claims**

1.  Pseudo-sine signal generation device (D), comprising i) a differential tunable integration means (SI) arranged to generate differential triangular signals with a chosen constant output amplitude from input differential square signals, and ii) a differential processing means (PM) arranged to apply a chosen transfer function to said differential triangular signals in order to reject at least a third harmonic thereof when the amplitude of said differential triangular signals is equal to said chosen constant output amplitude and then to output pseudo-sine signals with a quasi-constant amplitude, **characterized in that** it further comprises an additional harmonic rejection means (AM) coupled to said differential tunable integration means (SI) and arranged to reject the second harmonic of said differential triangular signals outputted by said differential tunable integration means (SI) before they feed said differential processing means (PM).

2.  Pseudo-sine signal generation device according to claim 1, **characterized in that** it further comprises an amplitude detection means (DM) arranged to compare the output amplitude of said differential triangular signals with said chosen constant output amplitude in order to deliver a control signal representative of a difference between these amplitudes, and **in that** said differential tunable integration means (SI) is arranged to adjust the output amplitude of the differential triangular signals it outputs depending on said control signal in order that this output amplitude be equal to said chosen constant output amplitude.

3. Pseudo-sine signal generation device according to one of claims 1 and 2, **characterized in that** said additional harmonic rejection means (AM) comprises a regulation loop for common mode regulation of said differential triangular signals and a cancellation loop for offset cancellation of said differential triangular signals.

4. Pseudo-sine signal generation device according to one of claims 1 to 3, **characterized in that** said differential processing means (PM) is a bipolar differential amplifier having a transfer function $V_{out}$ proportional to $\tanh(V_{in}/2V_t)$ where $V_{in}$ represents said differential triangular signals, $V_t = kT/q$, k being the Boltzmann constant, T being the absolute temperature in Kelvin and q being the electron charge, and **in that** said chosen constant output amplitude is equal to $\alpha * V_t$, where $\alpha$ is a constant.

5. Pseudo-sine signal generation device according to claim 4, **characterized in that** $\alpha$ is a constant included between 3 and 4.

6. Pseudo-sine signal generation device according to claim 5, **characterized in that** $\alpha$ is equal to 3.3.

7. Pseudo-sine signal generation device according to one of claims 1 to 3, **characterized in that** said differential processing means (PM) is a MOS differential amplifier having a transfer function $V_{out}$ depending on its polarization current and geometry, and **in that** said chosen constant output amplitude is equal to a value depending on said polarization current and geometry.

8. Pseudo-sine signal generation device according to one of claims 1 to 7, **characterized in that** said differential tunable integration means (SI) comprises a capacitor means and a tunable transconductor feeding said capacitor means and tunable by means of a control current defined by a control signal.

9. Pseudo-sine signal generation device according to one of claims 1 to 7, **characterized in that** said differential tunable integration means (SI) comprises a transconductor and a tunable capacitor means fed by said transconductor and tunable by means of a control voltage defined by a control signal.

10. Pseudo-sine signal generation device according to one of claims 1 to 7, **characterized in that** said differential tunable integration means (SI) comprises a current amplifier.and a tunable capacitor means fed by said current amplifier and tunable by means of a control voltage defined by a control signal.

11. Pseudo-sine signal generation device according to one of claims 1 to 7, **characterized in that** said differential tunable integration means (SI) comprises a capacitor means and a tunable current amplifier feeding said capacitor means and having a gain tunable by means of a control current or voltage defined by a control signal.

12. Pseudo-sine signal generation device according to claim 1 and 2 in combination with one of claims 8 to 11, **characterized in that** said amplitude detection means (DM) is arranged to output said control signal defining said control current or voltage.

13. Pseudo-sine signal generation device according to one of claims 1 to 12, **characterized in that** it further comprises a generator means (VS) arranged to generate said input differential square signals.

14. Pseudo-sine signal generation device according to one of claims 1 to 13, **characterized in that** it constitutes at least a part of an integrated circuit (IC).


**Patentansprüche**

1. Pseudosinussignalerzeugungsvorrichtung (D), umfassend: i) ein differenzielles abstimmbares Integrationsmittel (SI), das so ausgeführt ist, dass es differenzielle Dreiecksignale mit einer ausgewählten konstanten Ausgangsamplitude aus eingegebenen differenziellen Rechtecksignalen erzeugt, und ii) ein differenzielles Verarbeitungsmittel (PM), das so ausgeführt ist, dass es eine ausgewählte Übertragungsfunktion auf die differenziellen Dreiecksignale anwendet, um wenigstens eine dritte Oberwelle derselben zu unterdrücken, wenn die Amplitude der differenziellen Dreiecksignale gleich der ausgewählten konstanten Ausgangsamplitude ist, und anschließend Pseudosinussignale mit einer quasi- konstanten Amplitude ausgibt, **dadurch gekennzeichnet, dass** sie ferner ein zusätzliches Oberwellenunterdrückungsmittel (AM) umfasst, das mit dem differenziellen abstimmbaren Integrationsmittel (SI) gekoppelt ist und so ausgeführt ist, dass es die zweite Oberwelle der differenziellen Dreiecksignale, die vom differenziellen abstimmbaren Integrationsmittel (SI) ausgegeben werden, unterdrückt, bevor diese dem differenziellen Verarbeitungsmittel (PM) zugeführt werden.

2. Pseudosinussignalerzeugungsvorrichtung nach Anspruch 1, **dadurch gekennzeichnet, dass** sie ferner ein Amplitudenerfassungsmittel (DM) umfasst, das so ausgeführt ist, dass es die Ausgangsamplitude der differenziellen Dreieckssignale mit der ausgewählten konstanten Ausgangsamplitude vergleicht, um ein Steuersignal, das eine Differenz zwischen diesen Amplituden repräsentiert, zu liefern, und dass das differenzielle abstimmbare Integrationsmittel (SI) so ausgeführt ist, dass es die Ausgangsamplitude der differenziellen Dreieckssignale, die es ausgibt, in Abhängigkeit von dem Steuersignal einstellt, damit diese Ausgangsamplitude gleich der ausgewählten konstanten Ausgangsamplitude ist.

3. Pseudosinussignalerzeugungsvorrichtung nach irgendeinem der Ansprüche 1 und 2, **dadurch gekennzeichnet, dass** das zusätzliche Oberwellenunterdrückungsmittel (AM) eine Regelschleife für Gleichtaktregelung der differenziellen Dreieckssignale und eine Auslöschungsschleife für eine Versatzauslöschung der differenziellen Dreieckssignale umfasst.

4. Pseudosinussignalerzeugungsvorrichtung nach irgendeinem der Ansprüche 1 bis 3, **dadurch gekennzeichnet, dass** das differenzielle Verarbeitungsmittel (PM) ein bipolarer Differenzialverstärker ist, der eine Übertragungsfunktion $V_{out}$ proportional zu $\tanh(V_{in}/2V_t)$ aufweist, wobei $V_{in}$ die differenziellen Dreiecksignale repräsentiert, $V_t = kT/q$ ist, k die Boltzmannkonstante ist, T die absolute Temperatur in Kelvin ist und q die Elektronenladung ist, und dass die ausgewählte konstante Ausgangsamplitude gleich $\alpha * V_t$ ist, wobei $\alpha$ eine Konstante ist.

5. Pseudosinussignalerzeugungsvorrichtung nach Anspruch 4, **dadurch gekennzeichnet, dass** $\alpha$ eine Konstante ist, die zwischen 3 und 4 enthalten ist.

6. Pseudosinussignalerzeugungsvorrichtung nach Anspruch 5, **dadurch gekennzeichnet, dass** $\alpha$ gleich 3,3 ist.

7. Pseudosinussignalerzeugungsvorrichtung nach irgendeinem der Ansprüche 1 bis 3, **dadurch gekennzeichnet, dass** das differenzielle Verarbeitungsmittel (PM) ein MOS-Differenzialverstärker ist, der eine Übertragungsfunktion $V_{out}$ aufweist, die von dessen Polarisationsstrom und Geometrie abhängt, und dass die ausgewählte konstante Ausgangsamplitude gleich einem Wert ist, der vom Polarisationsstrom und der Geometrie abhängt.

8. Pseudosinussignalerzeugungsvorrichtung nach irgendeinem der Ansprüche 1 bis 7, **dadurch gekennzeichnet, dass** das differenzielle abstimmbare Integrationsmittel (SI) ein Kondensatormittel und einen abstimmbaren Transkonduktor umfasst, der das Kondensatormittel speist und mittels eines Steuerstroms, der durch ein Steuersignal definiert ist, abstimmbar ist.

9. Pseudosinussignalerzeugungsvorrichtung nach irgendeinem der Ansprüche 1 bis 7, **dadurch gekennzeichnet, dass** das differenzielle abstimmbare Integrationsmittel (SI) einen Transkonduktor und ein abstimmbares Kondensatormittel umfasst, das vom Transkonduktor gespeist wird und mittels einer Steuerspannung, die durch ein Steuersignal definiert ist, abstimmbar ist.

10. Pseudosinussignalerzeugungsvorrichtung nach irgendeinem der Ansprüche 1 bis 7, **dadurch gekennzeichnet, dass** das differenzielle abstimmbare Integrationsmittel (SI) einen Stromverstärker und ein abstimmbares Kondensatormittel umfasst, das vom Stromverstärker gespeist wird und mittels einer Steuerspannung, die durch ein Steuersignal definiert ist, abstimmbar ist.

11. Pseudosinussignalerzeugungsvorrichtung nach irgendeinem der Ansprüche 1 bis 7, **dadurch gekennzeichnet, dass** das differenziell abstimmbare Integrationsmittel (SI) ein Kondensatormittel und einen abstimmbaren Stromverstärker umfasst, der das Kondensatormittel speist und einen Verstärkungsfaktor aufweist, der mittels eines Steuerstroms oder einer Steuerspannung, die durch ein Steuersignal definiert sind, abstimmbar ist.

12. Pseudosinussignalerzeugungsvorrichtung nach Anspruch 1 oder 2 in Kombination mit einem der Ansprüche 8 bis 11, **dadurch gekennzeichnet, dass** das Amplitudenerfassungsmittel (DM) so ausgeführt ist, dass es das Steuersignal ausgibt, das den Steuerstrom oder die Steuerspannung definiert.

13. Pseudosinussignalerzeugungsvorrichtung nach irgendeinem der Ansprüche 1 bis 12, **dadurch gekennzeichnet, dass** sie ferner ein Generatormittel (VS) umfasst, das so ausgeführt ist, dass es die eingegebenen differenziellen Rechtecksignale erzeugt.

14. Pseudosinussignalerzeugungsvorrichtung nach irgendeinem der Ansprüche 1 bis 13, **dadurch gekennzeichnet, dass** sie wenigstens einen Teil einer integrierten Schaltung (IC) bildet.

## Revendications

1. Dispositif générateur de signaux pseudo-sinusoïdaux (D), comprenant i) des moyens différentiels d'intégration accordables (SI) agencés afin de générer des signaux triangulaires différentiels présentant une amplitude de sortie constante choisie à partir de signaux carrés différentiels en entrée, et ii) des moyens de traitement différentiels (PM) agencés pour appliquer une fonction de transfert choisie aux dits signaux triangulaires différentiels afin de rejeter au moins un troisième harmonique de ces signaux lorsque l'amplitude desdits signaux triangulaires différentiels est égale à ladite amplitude de sortie constante choisie et ensuite pour délivrer des signaux pseudo-sinusoïdaux avec une amplitude quasi constante, **caractérisé en ce qu'**il comporte, de plus, des moyens de rejet d'un harmonique supplémentaire (AM) couplés aux dits moyens d'intégration accordables différentiels (SI) et agencés pour rejeter le second harmonique desdits signaux triangulaires différentiels délivrés par lesdits moyens d'intégration accordables différentiels (SI) avant qu'ils soient fournis aux dits moyens de traitement différentiels (PM).

2. Dispositif générateur de signaux pseudo-sinusoïdaux selon la revendication 1, **caractérisé en ce qu'**il comprend, de plus, des moyens de détection d'amplitude (DM) agencés pour comparer l'amplitude de sortie desdits signaux triangulaires différentiels à ladite amplitude de sortie constante choisie afin de délivrer un signal de commande représentatif d'une différence entre ces amplitudes, et **en ce que** lesdits moyens d'intégration accordables différentiels (SI) sont agencés pour régler l'amplitude de sortie des signaux triangulaires différentiels qu'ils délivrent en fonction dudit signal de commande afin que cette amplitude de sortie soit égale à ladite amplitude de sortie constante choisie.

3. Dispositif générateur de signaux pseudo-sinusoïdaux selon l'une des revendications 1 et 2, **caractérisé en ce que** lesdits moyens de rejet d'un harmonique supplémentaire (AM) comprennent une boucle de régulation destinée à une régulation en mode commun desdits signaux triangulaires différentiels et un circuit d'annulation permettant une annulation par décalage desdits signaux triangulaires différentiels.

4. Dispositif générateur de signaux pseudo-sinusoïdaux selon l'une des revendications 1 à 3, **caractérisé en ce que** lesdits moyens de traitement différentiels (PM) sont constitués d'un amplificateur bipolaire différentiel ayant une fonction de transfert $V_{out}$ proportionnelle à $\tanh(V_{in}/2V_t)$, où $V_{in}$ représente lesdits signaux triangulaires différentiels , $V_t = kT/q$, k étant la constante de Boltzmann, T étant la température absolue en degrés Kelvin et q étant la charge d'électron, et **en ce que** ladite amplitude de sortie constante choisie est égale à $\alpha * V_t$, où $\alpha$ est une constante.

5. Dispositif générateur de signaux pseudo-sinusoïdaux selon la revendication 4, **caractérisé en ce que** $\alpha$ est une constante comprise entre 3 et 4.

6. Dispositif générateur de signaux pseudo-sinusoïdaux selon la revendication 5, **caractérisé en ce que** $\alpha$ est égal à 3,3.

7. Dispositif générateur de signaux pseudo-sinusoïdaux selon l'une des revendications 1 à 3, **caractérisé en ce que** ledit moyen de traitement différentiel (PM) est un amplificateur différentiel MOS ayant une fonction de transfert $V_{out}$ fonction de son courant de polarisation et de sa géométrie, et **en ce que** ladite amplitude de sortie constante choisie est égale à une valeur dépendant dudit courant de polarisation et de ladite géométrie.

8. Dispositif générateur de signaux pseudo-sinusoïdaux selon l'une des revendications 1 à 7, **caractérisé en ce que** lesdits moyens d'intégration accordables différentiels (SI) comportent des moyens de condensateur et un transducteur accordable alimentant lesdits moyens de condensateur et accordable à l'aide d'un courant de commande défini par un signal de commande.

9. Dispositif générateur de signaux pseudo-sinusoïdaux selon l'une des revendications 1 à 7, **caractérisé en ce que** lesdits moyens d'intégration accordables différentiels (SI) comprennent un transconducteur et des moyens de condensateur accordables alimentés par ledit transconducteur et accordables au moyen d'une tension de commande définie par un signal de commande.

**10.** Dispositif générateur de signaux pseudo-sinusoïdaux selon l'une des revendications 1 à 7, **caractérisé en ce que** lesdits moyens d'intégration accordables différentiels (SI) comprennent un amplificateur de courant et des moyens de condensateur accordables alimentés par ledit amplificateur de courant et accordables au moyen d'une tension de commande définie pa un signal de commande.

**11.** Dispositif générateur de signaux pseudo-sinusoïdaux selon l'une des revendications 1 à 7, **caractérisé en ce que** lesdits moyens d'intégration accordables différentiels (SI) comportent des moyens de condensateur et un amplificateur de courant accordable alimentant lesdits moyens de condensateur et ayant un gain accordable au moyen d'un courant ou d'une tension de commande définie par un signal de commande.

**12.** Dispositif générateur de signaux pseudo-sinusoïdaux selon la revendication 1 et 2 en combinaison avec l'une des revendications 8 à 11, **caractérisé en ce que** lesdits moyens de détection d'amplitude (DM) sont agencés en vue de délivrer ledit signal de commande définissant ledit courant ou ladite tension de commande.

**13.** Dispositif générateur de signaux pseudo-sinusoïdaux selon l'une des revendications 1 à 12, **caractérisé en ce qu'**il comprend, de plus, des moyens de générateur (VS) agencés pour générer lesdits signaux carrés différentiels en entrée.

**14.** Dispositif générateur de signaux pseudo-sinusoïdaux selon l'une des revendications 1 à 13, **caractérisé en ce qu'**il constitue au moins une partie d'un circuit intégré (CI).

FIG. 1

$A_c = \alpha \times V_t$

FIG. 2

FIG. 3

**EP 1 897 215 B1**

## REFERENCES CITED IN THE DESCRIPTION

### Patent documents cited in the description

- GB 1390510 A

- US 3961206 A